# EUROPEAN PATENT APPLICATION

(11) **EP 4 349 774 A1**
(43) Date of publication of application: **10.04.2024**
(21) Application number: 22816042.0
(22) Date of filing: 30.05.2022
(51) Int. Cl.: C01B 21/064, C08K 3/38, C08L 101/00, H01L 23/29, H01L 23/31

(54) **HEXAGONAL BORON NITRIDE POWDER**

(30) Priority: 02.06.2021 JP 2021093061; 02.06.2021 JP 2021093063
(71) Applicant: Tokuyama Corporation, Shunan-shi, Yamaguchi 745-8648 (JP)
(72) Inventor: DAIKI, Shota, Shunan-shi, Yamaguchi 745-8648 (JP); UEDA, Kohei, Shunan-shi, Yamaguchi 745-8648 (JP); KOIZUMI, Tetsuta, Shunan-shi, Yamaguchi 745-8648 (JP); HIROZANE, Yuuki, Shunan-shi, Yamaguchi 745-8648 (JP); IKEDA, Yuichi, Shunan-shi, Yamaguchi 745-8648 (JP); YOSHIDA, Satoru, Shunan-shi, Yamaguchi 745-8648 (JP)
(74) Representative: Kraus & Lederer PartGmbB
(86) International application number: PCT/JP2022/021916
(87) International publication number: WO 2022/255294

(57) **Abstract**

A hexagonal boron nitride powder of the present invention has a particle size distribution by a wet method in which the proportion of particles having a particle diameter in a range of 2.0 to 20 um is not less than 50 vol%, and the powder has a particle diameter d_{G} by a grind gauge measurement of not more than 44 um.

## Description

### Technical Field:

The present invention relates to a hexagonal boron nitride powder from which coarse particles have been removed to prevent increase of the amount of fine powder.

### Background Art:

Recently, due to the demand for smaller electronic parts and enhanced performance, semiconductor devices are becoming highly integrated, and at the same time, use amount of heat dissipating materials for effectively releasing heat generated at the device has been increased. Needless to note, improvement in the heat dissipation performance of the heat dissipating member is required. Various heat dissipating materials are used in the path to release the heat generated from the semiconductor device to the heat sink, to the housing or the like. For instance, a filler having high thermal conductivity is blended in a resin composition used for forming a sealing material, an adhesive, a grease, a resin sheet or the like for the purpose of heat dissipation. And recently, a ceramic substrate or a metal substrate made of aluminum nitride or silicon nitride with high thermal conductivity has been used more for the substrate on which the semiconductor device is to be mounted. Such a substrate is provided with an electrically insulating resin layer formed of a resin sheet (resin composition). A filler exhibiting high thermal conductivity is blended also in the resin sheet.

The sealing material is a material to fill the gap in the semiconductor device for the purpose of improving heat dissipation, namely, it is a hole filler. Resins are used for the sealing material suitably since the material is to be used to fill the gaps. A filler having high thermal conductivity is also blended in such a resin. With the recent trend for smaller semiconductor devices and high integration, the gap to be filled with the sealing material becomes narrower. Especially, there has been a demand for a sealing material suitable for a narrow gap of 30 µm or less. Therefore, the aforementioned filler of high thermal conductivity is also required to have a small particle diameter so as not to impair its capability to fill the narrow gap.

A hexagonal boron nitride powder is known as a filler exhibiting high thermal conductivity. The hexagonal boron nitride is also attracting attention from the viewpoint of weight reduction of parts because it is a light-weight filler with low specific gravity.

Patent Document 1 proposes a thin resin sheet in which hexagonal boron nitride of a small particle diameter is dispersed.

Patent Document 2 reports a boron nitride powder containing 0.1 to 5.0% by volume (vol%) of particles of 36 um or larger in a particle size distribution measured by wet laser diffraction.

However, removal of coarse particles from these hexagonal boron nitride powders are not sufficient, and thus, the high thermal conductivity of the hexagonal boron nitride is not fully utilized. Further improvement is required therefor.

For instance, as for a member like a resin sheet, a thinner sheet is advantageous to reduce the heat resistance. Recently, there has been a demand for a sheet having a thickness of 45 µm or less. In other words, when the filler contains a large amount of coarse particles, the coarse particles may pass through the sheet, and it may cause degradation in the dielectric strength. And furthermore, the thickness of the resin sheet may become uneven. This may cause another problem, that is, due to the removal of the coarse particles, the content of fine particles having a smaller particle diameter may also decrease, thereby lowering the thermal conductivity of the resin sheet. That is, the high thermal conductivity as a property of hexagonal boron nitride cannot be utilized sufficiently.

Needless to note, a filler containing a large amount of coarse particles in a sealing material is difficult to fill narrow gaps (for instance, a gap of 30 um or smaller), and this may cause problems such as uneven filling and voids. On the other hand, removal of the coarse particles decreases also the content of fine particles having a smaller particle diameter, and the thermal conductivity thereof may deteriorate similarly to the aforementioned case.

Considering these situations, in order to take advantage of the high thermal conductivity of the light-weight hexagonal boron nitride, the particles is required to have a particle size distribution corresponding to the application, particularly in the field of semiconductor.

### Prior Art Documents:

### Patent Documents:

[Patent Document 1] WO2015/122378 Publication
[Patent Document 2] WO2019/172440 Publication

### Summary of the Invention:

### Problem to be Solved by the Invention:

Accordingly, it is an object of the present invention to provide a hexagonal boron nitride powder useful as a filler with high thermal conductivity. The hexagonal boron nitride powder contains an appropriate amount of fine particles while coarse particles have been effectively removed.

It is another object of the present invention to provide a resin composition that contains the filler and that is suitably used for forming members to be used in the field of a semiconductor, such as a resin sheet or a sealing material (a hole filler).

### Means for Solving the Problems:

The present inventors carried out intensive studies for solving the aforementioned problems, thereby arriving at a finding as mentioned below. That is, if a conventional hexagonal boron nitride powder is simply classified using a dry sieve to remove coarse particles, the amount of coarse particles can be controlled but the amount of fine powders may be increased. And if this hexagonal boron nitride powder is blended in a resin, the required thermal conductivity may be impaired. The inventors continued the studies to find out that a hexagonal boron nitride powder favorably applicable as a target highly thermal conductive filler can be obtained by performing a specific wet classification so as to remove the coarse particles and to make the particle diameter d_{G} within a predetermined range by the grind gauge measurement, thereby completing the present invention.

The present invention provides a hexagonal boron nitride powder having a particle size distribution by a wet method in which the proportion of particles within a particle diameter range of 2.0 to 20 um is not less than 50 vol%, and having a particle diameter d_{G} by a grind gauge measurement of not more than 44 µm.

In the particle size distribution measurement by the wet method for the hexagonal boron nitride powder, 20 g of ethanol as a dispersion medium is introduced into a 50mL screw-tube bottle, and 1 g of hexagonal boron nitride powder is dispersed in the ethanol to prepare a measurement sample (ultrasonic dispersion is not employed for the dispersion) Particle size distribution of this measurement sample is measured using a laser diffraction-scattering type particle size distribution analyzer. For the measurement device, for instance, a particle size distribution measuring device MT3000 manufactured by Nikkiso Co., Ltd. may be used as described below in Examples, though the present invention is not limited to the example.

It is possible to determine the volume ratio of the particles of a predetermined particle diameter range, from the volume frequency distribution of the particle diameter obtained by this measurement. In this volume frequency distribution, D₅₀ represents the value of particle diameter at which the accumulated value of the volume frequency is 50%, D₉₅ represents the value of particle diameter at which the same frequency is 95%, and D₁₀₀ represents the value of particle diameter at which the same frequency is 100%.

The grind gauge measurement particle diameter d_{G} is measured according to JISK5600-2-5. Specifically, for the measurement, 1 part by mass of hexagonal boron nitride powder and 10 parts by mass of a silicone resin having a kinematic viscosity of 1000 cSt at 25°C are mixed to obtain a resin paste, and the resin paste is observed using a grind gauge to determine the point at which spots appear.

As for the hexagonal boron nitride powder of the present invention, the following embodiments are suitable.
(1) The proportion of particles in a particle diameter range of 5.0 to 20 um in the particle size distribution by the wet method is not less than 50 vol%.
(2) A ratio d_{G}/D₁₀₀ of the particle diameter d_{G} to the accumulated particle diameter D₁₀₀ in terms of volume in the particle size distribution by the wet method is 1.0 to 1.6.
(3) In the particle size distribution by the wet method, the proportion of the particles within the particle diameter range of 2.0 to 5.0 um is not less than 50 vol%, and the particle diameter d_{G} is not more than 29 um.
(4) The ratio d_{G}/D₁₀₀ of the particle diameter d_{G} to the accumulated particle diameter D₁₀₀ in terms of volume in the particle size distribution by the wet method is 1.0 to 2.3.

In particular, the powders of the (1) and (2) are suitable as fillers for thin resin sheets (e.g., the thickness is 45 µm or less). The powders of the above (3) and (4) are suitable as fillers to be used for sealing materials for small gaps (e.g., a gap of 30 µm or less).

Further, the present invention provides a resin composition containing the aforementioned hexagonal boron nitride powder dispersed in a resin in an amount of 30 to 90 vol%.

The resin composition is suitably used for forming a heat-dissipating member used in a semiconductor device or the like, and the following embodiments are employed particularly suitably.
(5) The resin is a silicone resin or an epoxy resin.
(6) The resin composition is to be used for forming a resin sheet, wherein the proportion of particles of the hexagonal boron nitride powder within the particle diameter range of 5.0 to 20 um in the particle size distribution by the wet method is not less than 50 vol%.
(7) The resin sheet has a thickness in a range of 20 to 45 um.
(8) The resin composition is to be used for forming a sealing material, wherein the proportion of particles of the hexagonal boron nitride powder within the particle diameter range of 2.0 to 5.0 um in the particle size distribution by the wet method is not less than 50 vol%, and the particle diameter d_{G} by the grind gauge measurement is not more than 29 um.
(9) The sealing material is used for filling a small gap of not larger than 30 um in a semiconductor device.

The present invention further provides a method for producing the hexagonal boron nitride powder described above, and the method includes steps described below:
preparing a raw material powder of a particulate matter of hexagonal boron nitride having a particle size distribution by a wet method in which a proportion of particles within a particle diameter range of 2.0 to 20 um is not less than 50 vol%;
dispersing the raw material powder in a solvent to prepare a raw material slurry in which the concentration of the raw material powder is not more than 14% by mass;
wet classification for removing coarse particles by passing the raw material slurry through a filter having a sieve opening of 5 um to 25 um; and
drying for removing the solvent from the slurry from which the coarse particles have been removed.

In the method, the following embodiments are preferably employed.
(10) A median particle diameter D₅₀ of the raw material powder in terms of volume in particle size distribution by a wet method is in the range of 5.0 to 20 um, and the filter to be used for removing the coarse particles has a sieve opening in the range of 15 um to 25 um.
(11) A median particle diameter D₅₀ of the raw material powder in terms of volume in particle size distribution by a wet method is in the range of 2.0 to 4.0 um, and the filter to be used for removing the coarse particles has a sieve opening in the range of 5 um to 15 um.

The embodiment of (10) is employed in production of a filler for a thin resin sheet (having a thickness of not more than 45 um for instance), and the embodiment of (11) is employed in production of a filler to be used for a sealing material for a small gap (for instance, a gap of 30 µm or less) in particular.

### Effect of the Invention:

The hexagonal boron nitride powder of the present invention contains less amount of coarse particles and an appropriate amount of fine particles. Therefore, it is extremely preferable to be used as a filler for a resin molding materials that is required to have high heat conductivity and dielectric strength. It can be used suitably as a filler to be blended in a resin sheet, a sealing material, and furthermore, an adhesive or grease, each of which is required to exhibit heat dissipating property in application using for semiconductor devices.

### Mode for Carrying Out the Invention:

### <Hexagonal boron nitride powder>

Since the hexagonal boron nitride (h-BN) powder of the present invention is used as a filler by taking advantage of high thermal conductivity and low specific gravity (light weight), favorably, it contains less amount of inevitable impurities, namely, it is preferably of a high purity. For instance, the amount of boron oxide as the impurity is not more than 400 ppm, preferably not more than 300 ppm, and most preferably not more than 250 ppm. Preferably, the carbon content is in a range of 0.001 to 0.050% by mass, and the oxygen content is 0.01 to 0.95% by mass.

The primary particles of the h-BN particles composing the powder usually have an average aspect ratio (major diameter / thickness) of 3 to 20, particularly 5 to 15. If the aspect ratio is less than 3, the production may be difficult. If the aspect ratio is increased excessively, the particle will have a flake shape with a longer major diameter, and the dielectric strength may deteriorate. Therefore, it is preferable to set the conditions for production so that the aspect ratio is not increased more than required in producing the h-BN particles.

The hexagonal boron nitride powder of the present invention composed of h-BN particles is characterized in that the proportion of particles in a particle diameter range of 2.0 to 20 um in the particle size distribution by the wet method is 50 vol% or more, and is also characterized in that the coarse particles are removed such that a particle diameter d_{G} taken by a grind gauge measurement is 44 µm or less.

That is, as is apparent from the wet particle size distribution properties described above, the h-BN powder of the present invention contains a large amount of particles having a particle diameter of about 5 to about 20 um. Thereby, an effective thermal conduction path is formed. As a result, for instance, excellent thermal conductivity is imparted to the sealing material to be filled in a thin resin sheet or a narrow gap (e.g., a space between two opposing substrates). For this reason, the powder can be used in a semiconductor device or the like to obtain the heat dissipating property.

That is, in the aforementioned wet particle size distribution measurement, only the particles contained in a certain amount or more are counted, while particles actually is contained may not be indicated on the particle size distribution. In some cases, aggregated coarse particles may be loosened slowly during dispersion in the solvent. For this reason, the actual hexagonal boron nitride powder contains often particles larger than D₁₀₀ measured according to the wet particle size distribution. As can be understood from this, it is impossible to reliably count the coarse particles or aggregated particles in the wet particle size distribution measurement. For instance, in a case where the h-BN powder having the aforementioned wet particle size distribution property is blended in a sealing material to be filled in a thin resin sheet or a narrow gap, problems such as uneven thickness or failure in gap filling may occur.

On the other hand, as for the h-BN powder of the present invention, the coarse particles are removed so that the particle diameter d_{G} according to the grind gauge measurement is to be 44 µm or less. Therefore, the aforementioned disadvantages can be reliably prevented even in a case where the powder is blended in a sealing material to fill a resin sheet having a thickness of not more than 45 um or a small gap of not more than 45 um. That is, the presence of coarse particles is detected in the grind gauge measurement due to spots that may be formed even if the amount of the coarse particles is extremely small. Therefore, it is possible to control the amount of coarse particles and aggregated particles that do not appear in the particle size distribution measurement by the wet method.

Therefore, when the h-BN powder of the present invention is used as a filler to be blended in the sealing material to be filled in a resin sheet having a thickness of X um or a gap (space) of X um, the particle diameter d_{G} is set to (X-1) µm or less.

It is also preferable that the hexagonal boron nitride powder of the present invention contains aggregated particles composed of aggregated single particles. In a case where the primary particles of the hexagonal boron nitride of the present invention has a flat shape, it shows anisotropy in thermal conductivity when blended in a resin. Sometimes, the thermal conductivity of the particles is high in the width direction of the particles, while the thermal conductivity is low in the thickness direction of the particles. The anisotropy in the thermal conductivity is considerable particularly for the sealing material to fill a thin resin sheet or a narrow gap, and the thermal conductivity may be low in some direction. However, when the primary particles are aggregated, the single particles are oriented randomly in the aggregate. As a result, the anisotropy in the thermal conductivity may be reduced or prevented and a low thermal conductivity in certain directions can be prevented effectively.

In the present invention, the presence of aggregated particles in the h-BN powder can be confirmed from the ratio (D_{50S}/D₅₀) of D_{50S} calculated from the wet particle size distribution in which the ultrasonication is performed and D₅₀ in the wet particle size distribution. That is, since the aggregated particles are disintegrated by ultrasonic waves, the value of D_{50S}/D₅₀ becomes small if a large amount of the aggregated particles are contained. For instance, D_{50S}/D₅₀ is preferably from 0.40 to 0.85, particularly from 0.50 to 0.80.

Note that the wet particle size distribution measurement for an ultrasonication can be performed in the same manner as in the case where the ultrasonication is not performed, except that in the preparation of the measurement sample, an ultrasonication is performed at 90 W for 20 minutes after 20 g of ethanol as a dispersion medium is introduced into a 50mL screw-tube bottle and 1 g of hexagonal boron nitride powder is dispersed in the ethanol.

In a case where the h-BN powder of the present invention is used as a filler to be blended into a thin resin sheet, the following embodiment (A) is preferred. In a case where it is used as a sealing material to be filled in a small gap, the following embodiment (B) is particularly preferred.

### Suitable embodiment (A)

In a case of the present invention where the h-BN powder is used as a filler to be blended in a thin resin sheet having a film thickness of 20 to 45 um, it is preferable that a proportion of particles having a particle diameter of 5 to 20 um in a particle size distribution by a wet method is 50 vol% or more, preferably 60 vol% or more, and more preferably 70 vol% or more, because an effective thermal conduction path is formed by particles having a particle diameter of about 5 to 20 µm.

In the particle size distribution by the wet method, preferably D₅₀ may be 4.0 um or more, more preferably 4.5 um or more, still more preferably 5.0 um or more, and most preferably 6.0 um or more. The upper limit of D₅₀ may be 9.0 µm or less, more preferably 8.5 µm or less, still more preferably 8.3 um or less, and most preferably 8.0 µm or less.

D₉₅ may be 9.5 um or more, more preferably 10.0 um or more, still more preferably 10.5 um or more, and most preferably 11.0 um or more. And, the upper limit of D₉₅ may be 19.0 µm or less, more preferably 18.5 µm or less, still more preferably 18.0 um or less, and most preferably 17.5 µm or less.

Further, D₁₀₀ is preferably 35 µm or less.

As for the thin resin sheet, a high thermal conductivity may be hardly obtained when D₅₀ or D₉₅ is smaller than the ranges. When D₅₀ or D₉₅ is larger than the ranges, the dielectric strength tends to be degraded. When D₁₀₀ exceeds 35 um, excessively large coarse particles may be mixed in the thin sheet, thereby degrading the dielectric strength.

In a case where the powder is used in the thin resin sheet, the particle diameter d_{G} according to the grind gauge measurement is suitably 20 um or more so that higher thermal conductivity can be imparted.

In order to obtain higher thermal conductivity, the ratio (d_{G}/D₁₀₀) of the grind gauge measurement particle diameter d_{G} (µm) to D₁₀₀ (µm) in the particle size distribution by the wet method may be 1.0 to 1.6, preferably 1.0 to 1.5, and more preferably 1.0 to 1.4. When this ratio is larger than necessary, it may be difficult to obtain a high thermal conductivity in the resin sheet having a film thickness of 20 to 45 um. It is difficult to produce a powder having the ratio of less than 1.0.

As for the h-BN powder of the present invention, which has the aforementioned particle size property, a BET specific surface area measured by the nitrogen-adsorption one-point method is in a range from 3.0 to 6.0 m²/g, more preferably from 3.2 to 5.7 m²/g, and most preferably from 3.5 to 5.0 m²/g. When the BET specific surface area is excessively small, the particle diameter of the hexagonal boron nitride single particle is large. In a case where the single particles are aggregated or the single particles are elliptical or elongated, particularly, coarse particles may be present more to further cause degradation in the dielectric strength. If the BET specific surface area is excessively large, coarse particles may be generated easily by aggregation due to the small particle diameter of the primary particles. This is unsuitable for forming a thin resin sheet.

### Suitable embodiment (B)

In the present invention, in a case where the h-BN powder is used as a filler to be blended in a sealing material to be filled in a particularly narrow gap, for instance, a gap of 5 to 30 um, it is desirable that the particle diameter is smaller than the particle diameter of a powder used for a resin sheet. It is preferable that the proportion of particles having a particle diameter of 2.0 to 5.0 um in a particle size distribution by a wet method is 50 vol% or more, and more preferably 60 vol% or more, because an effective thermal conduction path is formed with the particles having a particle diameter of about 2.0 to about 5.0 µm.

As for the particle size distribution by the wet method in this embodiment, D₅₀ is preferably 2.0 um or more, and more preferably 2.1 um or more. The upper limit of D₅₀ is preferably 4.0 µm or less, and more preferably 3.8 µm or less.

D₉₅ may be 4.5 um or more, and more preferably 4.8 um or more. The upper limit of D₉₅ may be 7.0 µm or less, and more preferably 6.7 µm or less.

D₁₀₀ is preferably 15 µm or less.

As for the sealing material to be filled in the small gap, if D₅₀ and D₉₅ are smaller than the ranges, the viscosity of the sealing material may increase, and the performance in filling the narrow gap may be impaired. If D₅₀, D₉₅ and D₁₀₀ are larger than the ranges, it will be difficult to be filled in a narrow gap with the sealing material due to the presence of large particles.

Further, as for the filler used in the sealing material to be filled in particularly narrow gaps, the grind gauge measurement particle diameter d_{G} is required to be 29 um or less. In order to obtain higher thermal conductivity, the particle diameter d_{G} is suitably 4.0 um or more.

In order to obtain higher thermal conductivity for this sealing material, it is preferable that a ratio (d_{G}/D₁₀₀) of the grind gauge measurement particle diameter d_{G} (µm) to D₁₀₀ (um) in the particle size distribution by the wet method is 1.0 to 2.3, and more preferably 1.0 to 2.1. If the ratio is larger than necessary, the number of particles to efficiently impart the thermal conductivity is reduced, and it will be difficult to obtain a high thermal conductivity required for the sealing material. As described above, it is difficult to produce a powder having the ratio of less than 1.0.

As for the h-BN powder of the present invention, which has the aforementioned particle size properties, the BET specific surface area measured by the nitrogen-adsorption one-point method is preferably in the range of 6.0 to 12.0 m²/g, more preferably 6.5 to 11.0 m²/g. If the BET specific surface area is excessively small, the particle diameter of the hexagonal boron nitride single particle is large. In particular, if the single particles are aggregated or if the single particles are elliptical or elongated, coarse particles may be present more, whereby degradation in dielectric strength may easily occur. If the BET specific surface area is excessively large, the coarse particles may be generated more by aggregation due to the small diameter of the primary particles, and this is unsuitable for filling in a gap having an opening diameter of 30 µm or less.

### <Production of hexagonal boron nitride powder>

The aforementioned h-BN powder of the present invention is produced by preparing a particulate matter of h-BN having a predetermined particle size distribution as a raw material powder, using this raw material powder for preparation of a raw material slurry having a predetermined concentration, removing coarse particles from the raw material slurry by wet classification, and drying in the final step.

### Raw material powder

In the present invention, there is no particular limitation on the method for producing a raw material powder formed of a particulate matter of h-BN. The raw material can be obtained by, for instance, producing the h-BN by any known method such as a reduction-nitriding method or a melamine method, removing coarse particles from the obtained particulate matter by dry classification, and making a powder containing 50 vol% or more of particles having a particle diameter of 2.0 to 20 um in a particle size distribution by a wet method.

The production of h-BN by the reduction-nitriding method includes for instance: mixing an oxygen-containing boron compound such as boric acid or boron oxide, a carbon source such as carbon black, and an oxygen-containing calcium compound such as calcium carbonate; and heating the mixture to a maximum temperature in a range of 1500 to 1700°C in a nitrogen atmosphere for reduction-nitriding.

The ratio in the amounts of the respective compounds during the reaction is set so that B/C (elemental ratio) is in the range of 0.75 to 1.00. The amount of the oxygen-containing calcium compound in terms of CaO based on Ca is 4 to 15 parts by mass per 100 parts by mass of the total amount of the oxygen-containing boron compound amount in terms of B₂O₃ based on B and the carbon source amount in terms of C.

The production of h-BN by the melamine method is performed by heating a mixed powder containing a boron oxide such as B₂O₃ (boron trioxide) and a nitrogen-containing organic compound represented by melamine at a maximum temperature of 1000°C or higher and 1500°C or lower. The use ratio of the boron oxide to the nitrogen-containing organic compound in this mixed powder is usually set so that the mass ratio (B/N) of the boron atom (B) to the nitrogen atom (N) is 0.30 to 1.00, particularly 0.35 to 0.95.

This method is advantageous in producing a h-BN powder for filler to be blended in a sealing material used for filling in a smaller gap particularly, since boron nitride with smaller particle diameter can be obtained easily.

Since the particulate matter of h-BN obtained in this manner is in an aggregated state, if required, it is crushed using a roll crusher, a jet mill, a bead mill, a planetary mill, a stone grinder or the like.

After crushing is performed as required, acid pickling is carried out since an oxide such as boron oxide or a composite oxide composed of boron oxide and calcium oxide is contained as an impurity. For instance, an acid pickling is performed by crushing the particulate matter of h-BN and introducing it into a vessel, adding thereto a dilute hydrochloric acid (5 to 20 % by mass of HCl) in an amount 5 to 10 times the particulate matter, and making them contact for 4 to 8 hours. Not only the hydrochloric acid, but other acids such as nitric acid, sulfuric acid or acetic acid can also be used.

After the acid pickling, for the purpose of washing the remaining acid, washing is performed using pure water. After washing with water, drying is performed by heating in an atmosphere at 50 to 250°C or under reduced pressure, so that the water content becomes substantially 0%.

The thus obtained particulate matter of h-BN is subjected to wet classification described later. Preferably, it is subjected to dry classification before the wet classification so as to remove coarse particles and fine powder to some extent, if necessary.

This dry classification can be carried out by a dry sieve, an air flow classification or the like, whereby a h-BN raw material powder containing 50 vol% or more of particles having a particle diameter in a range from 2.0 to 20 um in a particle size distribution measured by a wet method can be easily obtained.

In order to obtain a powder of h-BN containing 50 vol% or more of particles having a particle diameter (5 to 20 um or 2.0 to 5.0 um) suitable for a thin resin sheet or a sealing material to be filled in a narrow gap by the above dry classification, it is preferable to use a dry sieve having a sieve opening of 38 to 90 um. If a sieve having a sieve opening smaller than 38 µm is used, the primary particles cause clogging due to the presence of primary particles having a flat shape, and a continuous process may be difficult. Even if a dry sieve having a sieve opening of 38 µm is performed, particles of a size equal to or smaller than the diagonal of a sieve opening pass through the sieve. Therefore, in a case of using the dry sieve, it is impossible to set a grind gauge measurement particle diameter d_{G} to 44 µm or less.

In this manner, it is possible to obtain a raw material powder of a particulate matter of h-BN suitable for a wet classification process described later, in which the average aspect ratio of the primary particle is 5 to 15 and the content rate of flake particles having a large aspect ratio is lower.

### Raw material slurry preparation

The thus obtained raw material powder is dispersed in a solvent to form a slurry.

The solvent used for forming the slurry is not particularly limited as long as the h-BN particles can be dispersed therein, and the examples include water (ion-exchanged water, pure water); alcohols such as methanol, ethanol, propanol, isopropyl alcohol, and butanol; and ketones such as acetone and methyl ethyl ketone. These solvents may be used alone or as a mixed solvent of two or more of them.

The solvent is set so that the concentration of the raw material powder (h-BN particulate matter) contained in the slurry is 14% by mass or less, particularly 12% by mass or less, and most preferably 5% by mass or less. It is optimal to use a solvent in an amount such that the viscosity at 25°C of the slurry becomes 1.0 to 60 mPa·S, particularly depending on the type of the solvent and the like. Accordingly, the h-BN particulate matter can be uniformly dispersed in the slurry without increasing the viscosity of the slurry. In addition to that, the subsequent process (removal of coarse particles) can be easily performed. If the concentration of the raw material powder in the slurry is high, the dispersibility of the raw material powder is lowered. In this case, the hexagonal boron nitride powder finally obtained contains numbers of smaller particles of a diameter of less than 5 um, making it difficult to obtain high thermal conductivity. In consideration of the processing efficiency, the concentration of the raw material powder in the slurry is preferably 1% by mass or more.

The slurry preparation by dispersing the raw material powder in a solvent is not particularly limited, and it may be performed by measuring and mixing a predetermined amounts of the raw material powder (h-BN particulate matter) and the solvent.

In many cases, a raw material powder (a particulate matter of h-BN) before dispersing in a solvent is in a state in which most of the particles are loosely aggregated. Therefore, it is preferable to process the slurry using a dispersing apparatus to sufficiently disperse the raw material powder. This can prevent or reduce clogging during the process in the next step.

For the dispersing apparatus, for instance, a disperser, a homogenizer, an ultrasonic disperser, a nanomizer, a planetary mixer, an ejector, a water jet mill, a high-pressure dispersing apparatus, a wet ball mill, aa wet vibrating ball mill, a wet bead mill or the like can be used. Most preferably, a disperser, a homogenizer, or an ultrasonic dispersing apparatus may be used.

### Wet classification step

The raw material slurry prepared in this manner is subjected to wet classification to remove coarse particles from the raw material slurry. That is, by removing the coarse particles by the wet classification, it is possible to efficiently remove coarse particles, whereby a hexagonal boron nitride powder of the present invention having a particle diameter d_{G} of 44 um or less according to grind gauge measurement can be obtained.

The wet classification is performed by filter classification of passing a raw material slurry through a filter having a sieve opening of 5 um to 25 um. That is, the diagonal spacing of the sieve opening is larger than 25 um. By using the filter, coarse particles having a particle diameter d_{G} of more than 44 um can be reliably removed.

By changing the sieve opening of the filter within the aforementioned range, it is possible to make the particle diameter d_{G} smaller, to decrease the particle diameter of the particle amount exceeding 50 vol% in the wet particle size distribution, or further, to change the values of D₅₀, D₉₅, and/or D₁₀₀. For instance, by using a filter having a sieve opening smaller than 15 um, it is possible to adjust the particle diameter of the particle amount exceeding 50 vol% in the wet particle size distribution to be in the range of 2.0 to 5.0 um. And further, it is possible to reduce the grind gauge measurement particle diameter d_{G} to 39 µm or less.

There is no particular limitation on the material, the structure, the shape or the like of the filter. For instance, a membrane filter, a resin filter, a metal filter, a filter paper or the like can be used. A resin filter or a stainless-steel filter is suitable since a high-purity hexagonal boron nitride powder can be easily obtained. Since the classification point, the classification accuracy, the degree of clogging and the like vary depending on the type and nature of the filter, it may be appropriately selected according to the physical properties of the raw material powder and the intended grind gauge measurement particle diameter d_{G}.

In a case where water-washing is not carried out after acid-pickling in the step of preparing the raw material powder, it is necessary to use a resin filter since the slurry becomes acidic.

Furthermore, by immersing in advance the filter in a solvent used for preparing a raw material slurry, compatibility between the slurry and the filter is improved, and filtration can be efficiently performed.

A method of passing the raw material slurry through the filter is not particularly limited, and any known methods such as a gravity type, a suction type, a pressure type, or a pressure feed type can be used. Among them, a method of introducing the raw material slurry into a cylindrical filter equipped with a screw rotating inside thereof is preferred. This method has an advantage that wet classification can be efficiently performed because clogging can be prevented or reduced by the centrifugal force of the screw.

### Drying step

After the wet classification, the slurry that has passed through the sieve is collected and dried, whereby the solvent is removed and the target hexagonal boron nitride powder of the present invention is obtained.

The means for drying is not particularly limited, and drying may be performed, for instance, by heating the slurry under the sieve with a heater.

Any heater can be used without particular limitation as long as the solvent can be vaporized and removed from the slurry. Specific examples of heater that can be used suitably include a conical dryer, a drum dryer, a V-type dryer, a vibration dryer, a rocking mixer, a Nauta mixer, RIBOCONE, a vacuum granulator, a vacuum emulsifier, and other stirring vacuum dryers.

Drying may be performed in a plurality of stages. Before heating in a heater, a part of the solvent may be removed using for instance, a rotary evaporator, a thin film dryer, a spray dryer, a drum dryer, a disk dryer, a fluidized bed dryer or the like. Further, before drying by heating in a heater, filtration may be performed to remove a part of the solvent. The apparatus for filtration can be suitably used as long as it is an apparatus for separating the slurry into a solid component and a liquid component. Specific examples thereof include a suction filtration apparatus, a centrifugal filter, a decanter, a Guinard centrifuge, a pressure filter, a filter press machine, and a filtration dryer capable of both filtration and drying. The material of the filter medium to be used, the retained particle diameter, the conditions of separation and the like may be appropriately selected depending on the employed method and the collection rate.

Although there is no particular limitation on the atmosphere during the heating in the heater, a vacuum, an inert gas atmosphere and a dry air atmosphere are preferred. Among them, a vacuum or an inert gas atmosphere is more preferred as it is less affected by environmental moisture, and a vacuum is particularly preferred.

As for the drying process, preferably removal of the solvent from the slurry is carried out until the mass change rate becomes lower than 0.9%. The mass change rate is calculated before and after allowing the obtained h-BN powder to stand at 120°C for 3 minutes in atmosphere.

### <Resin composition>

The hexagonal boron nitride powder of the present invention, which is a filler to improve the thermal conductivity, is blended in a resin so as to form a resin composition, and it is appropriately molded and used in various applications (typically, a resin sheet or a sealing material).

Though the resin is not particularly limited as long as it can be molded into a form suitable to be used, it is typically a silicone resin or an epoxy-based resin.

Examples of the epoxy resin are as follows:
bisphenol A type epoxy resin;
bisphenol S type epoxy resin;
bisphenol F type epoxy resin;
bisphenol A type hydrogenated epoxy resin;
polypropylene glycol type epoxy resin;
polytetramethylene glycol type epoxy resin;
naphthalene type epoxy resin;
phenylmethane type epoxy resin;
tetrakis phenolmethane type epoxy resin;
biphenyl type epoxy resin;
phenol novolac type epoxy resin;
tetrafunctional naphthalene type epoxy resin;
cresol novolac type epoxy resin;
dicyclopentadiene type epoxy resin;
trisphenol epoxy resin;
naphthol novolac epoxy resin;
naphthylene ether type epoxy resin;
aromatic glycidylamine type epoxy resin;
hydroquinone type epoxy resin;
stilbene type epoxy resin;
triphenolmethane type epoxy resin;
aralkyl type epoxy resin;
polypropylene glycol type epoxy resin;
polysulphide modified epoxy resin;
epoxy resin having a triazine nucleus in the skeleton; and
epoxy resin of bisphenol A alkylene oxide adduct type.

One of the epoxy resins exemplified above may be used alone or as a mixture of two or more thereof.

For the curing agent which may be used in combination, it is also possible to use also an amine-based resin, an acid anhydride-based resin, a phenol-based resin, imidazoles, an active ester-based curing agent, a cyanate ester-based curing agent, a naphthol-based curing agent, a benzoxazine-based curing agent or the like.

Similarly, one of these curing agents may be used alone or as a mixture of two or more thereof. The curing agent may be blended in the epoxy resin at an equivalent ratio of 0.5 to 1.5, and preferably 0.7 to 1.3. In the present specification, these curing agents are also included in the resin.

For the silicone resin, a known curable silicone resin that is a mixture of an addition-reaction type silicone resin and a silicone-based crosslinking agent can be used without any substantial limitations.

Representative examples of the addition-reaction type silicone resin include polyorganosiloxanes such as polydimethylsiloxane that has an alkenyl group like a vinyl group or a hexenyl group as a functional group in its molecule. The silicone-based crosslinking agent is a polyorganosiloxane having a silicon atom-bonded hydrogen atom, and the examples include:
dimethyl hydrogen siloxy group end-capped dimethylsiloxane-methylhydrodiene siloxane copolymer;
trimethylsiloxy group end-capped dimethylsiloxane-methylhydrogen siloxane copolymer;
trimethylsiloxane group end-capped poly(methylhydrodiene siloxane); and
poly(hydrodiene silsesquioxane).

A known catalyst to be used for curing a silicone resin may be blended in the resin composition. Examples of the curing catalyst include fine particulate platinum, fine particulate platinum supported on a carbon powder, chloroplatinic acid, alcohol-modified chloroplatinic acid, an olefin complex of chloroplatinic acid, palladium, and a rhodium catalyst.

In addition to the epoxy resins and the silicone resins, various resins also can be used.

Examples of the resin include a liquid crystal polymer, polyester, polyamide, polyimide, polyphthalamide, polyphenylene sulfide, polycarbonate, polyaryletherketone, polyphenylene oxide, fluororesin, cyanate ester compound, and maleimide compound.

Examples of the liquid crystal polymer include a thermotropic liquid crystal polymer exhibiting liquid crystallinity in a molten state and a rheotropic liquid crystal polymer exhibiting liquid crystallinity in a solution state. And any of these liquid crystal polymers may be used.

Examples of the thermotropic liquid crystal polymer include: a polymer synthesized from parahydroxybenzoic acid (PHB), terephthalic acid, and 4,4'-biphenol; a polymer synthesized from PHB and 2,6-hydroxynaphthoic acid; and a polymer synthesized from PHB, terephthalic acid, and ethylene glycol.

Examples of the fluororesin include
polytetrafluoroethylene resin (PTFE),
polytetrafluoroethylene-hexafluoropropylene copolymer resin (PFEP), and polytetrafluoroethylene perfluoroalkylvinyl ether copolymer resin (PFA).

Examples of the cyanate ester compounds include:
phenol novolak type cyanate ester compound;
naphthol aralkyl type cyanate ester compound;
biphenyl aralkyl type cyanate ester compound;
naphthylene ether type cyanate ester compound;
xylene resin type cyanate ester compound; and
adamantane skeleton type cyanate ester compound. Among them, a phenol novolac type cyanate ester compound, a biphenyl aralkyl type cyanate ester compound, and a naphthol aralkyl type cyanate ester compound are preferred.

Examples of the maleimide compounds include:
N-phenylmaleimide;
N-hydroxyphenylmaleimide;
bis(4-maleimidophenyl)methane;
2,2-bis{4-(4-maleimidophenoxy)-phenyl}propane;
bis(3,5-dimethyl-4-maleimidophenyl)methane;
bis(3-ethyl-5-methyl-4-maleimidophenyl)methane;
bis(3,5-diethyl-4-maleimidophenyl)methane; and
a maleimide compound represented by the following formula (1) or the following formula (2).

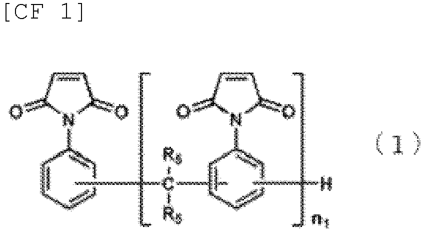

In the formula (1),
R₅ each represents independently a hydrogen atom or a methyl group, preferably a hydrogen atom,
n₁ represents an integer of 1 or more, preferably an integer of 10 or less, and more preferably an integer of 7 or less.

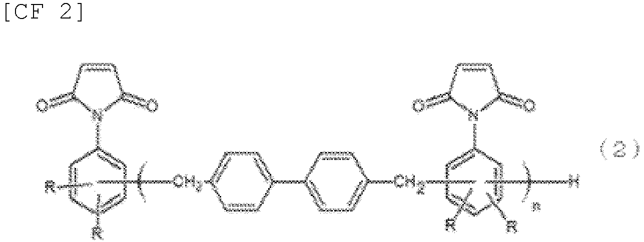

In the formula (2),
each of the plurality of R represents independently a hydrogen atom, an alkyl group having 1 to 5 carbon atoms, or a phenyl group, and
n is an integer from 1 to 20.

Examples of the alkyl group include a methyl group, an ethyl group, an n-propyl group, an isopropyl group, an n-butyl group, an isobutyl group, a t-butyl group, and an n-pentyl group. For the group R, from the viewpoint of further improving the flame resistance and peel strength, it is preferably a hydrogen atom, a methyl group or a phenyl group. More preferably, it is a hydrogen atom or a methyl group, and most preferably, a hydrogen atom.

In the resin composition, the h-BN powder of the present invention is present in an amount of 30 to 90 vol%, preferably 40 to 80 vol%, and more preferably 50 to 70 vol%, thereby imparting excellent thermal conductivity to various materials formed from the resin composition.

The resin composition may contain various components in accordance with the application. Namely, it may contain appropriately the component in a range not affecting the effects of the present invention, and the examples include: inorganic fillers such as aluminum oxide, magnesium oxide, silica, and aluminum nitride; a curing accelerator; a discoloration inhibitor; a surfactant; a dispersant; a coupling agent; a colorant; a plasticizer; a viscosity modifier; and an antibacterial agent.

The resin composition of the present invention is suitably applied to, for instance, an adhesive film, a sheet-like laminated material (resin sheet) such as a prepreg, a circuit board (for a laminate or a multilayer printed circuit board), a solder resist, an underfill material, a thermal adhesive, a die bonding material, a semiconductor sealing material, a hole-filling resin, a part-embedding resin, a thermal interface material (a sheet, a gel, a grease and the like), a power module substrate, and a heat dissipation member for electronic part. The resin composition is applied particularly suitably to a resin sheet or a sealing material.

The resin composition is particularly suitable for a thin resin sheet having a film thickness of 20 to 45 um.

Although there is no particular limitation on the application of the resin sheet, it can be used, for instance, to a circuit board (particularly, a copper-clad laminate in which a resin composition and a copper foil are laminated) or an insulating layer of a multilayer printed circuit board. In the applications, by using a thin resin sheet, it is possible to reduce the thermal resistance or to make smaller devices.

Examples of suitable resins for the copper-clad laminates include an epoxy resin, a polyimide resin, a liquid crystal polymer, a fluororesin, a cyanate ester compound, and a maleimide compound. Among these resins, a fluororesin is particularly suitable in the application of the copper-clad laminate to be mounted on an electronic communication device such as a receiving device for satellite broadcasting or a cellular phone because of its excellent high frequency characteristics, heat resistance, weather resistance, chemical resistance, and water repellency. In a case where the circuit board is manufactured using lead-free solder, a liquid crystal polymer having high heat resistance is suitably used since the reflow temperature of the lead-free solder is about 260°C. A thermotropic liquid crystal polymer is particularly suitable since it is further favorable in heat resistance and flame retardance.

Another preferred embodiment in application to the copper-clad laminate is use of an epoxy resin and/or a maleimide compound together with a cyanate ester compound. This resin composition may facilitate to provide a resin component excellent in peel strength or hygroscopic heat resistance. Examples of epoxy resin preferred in this case from the viewpoint of flame retardancy and heat resistance include a biphenyl aralkyl type epoxy resin, a naphthylene ether type epoxy resin, a polyfunctional phenol type epoxy resin, and a naphthalene type epoxy resin. Examples of maleimide compound preferred from the viewpoint of thermal expansion coefficient and glass transition temperature include a 2,2'-bis{4-(4-maleimidophenoxy)-phenyl}propane, a bis(3-ethyl-5-methyl-4-maleimidophenyl)methane, a maleimide compound represented by the above formula (1), and a maleimide compound represented by the above formula (2). Examples of cyanate ester compound preferred from the viewpoint of glass transition temperature and plating adhesion include a phenol novolac type cyanate ester compound, a biphenyl aralkyl type cyanate ester compound and a naphthol aralkyl type cyanate ester compound.

As for a resin to be used as an insulating layer of a multilayer printed circuit board, an epoxy resin is preferred because of its excellent heat resistance and adhesion to a copper foil circuit. In order to obtain a resin composition having excellent flexibility and to improve the breaking strength of the insulating layer, it is preferable to use an epoxy resin that is liquid at a temperature of 20°C together with an epoxy resin that is solid at a temperature of 20°C. Preferred examples of the epoxy resin that is liquid at a temperature of 20°C include bisphenol A type epoxy resin, bisphenol F type epoxy resin, and naphthalene type epoxy resin. Preferred examples of the epoxy resin that is solid at a temperature of 20°C include a tetrafunctional naphthalene type epoxy resin, a biphenyl type epoxy resin, and a naphthylene ether type epoxy resin. The blending ratio of the epoxy resin that is liquid at a temperature of 20°C to the epoxy resin that is solid at a temperature of 20°C is preferably in the range of 1:0.1 to 1:4, and more preferably 1:0.8 to 1:2.5 in terms of mass ratio.

Examples of the sealing material include an underfill material and a grease-like thermal interface material. They can be used particularly suitably for filling a small gap of 5 to 30 um. In other words, the h-BN powder of the present invention is suitable for a sealing material to fill a narrow gap because they are free of coarse particles, and they have a particle size distribution to impart high thermal conductivity in a sealing material to fill a gap of 5 to 30 µm.

In a case where the resin composition of the present invention is used as an underfill material, the resin is preferably an epoxy resin from the viewpoint of heat resistance, moisture resistance, mechanical strength and the like. And use of an epoxy resin that is liquid at ordinary temperature is particularly preferable.

In a case where the resin composition of the present invention is used as a grease-like thermal interface material, a silicone resin is preferably used as the resin. For the silicone resin, it is preferable to use a polyorganosiloxane represented by the following formula (3) as an addition-reaction type silicone resin and a polyorganosiloxane having at least a silicon atom-bonded hydrogen atom in one molecule as a silicone-based crosslinking agent.

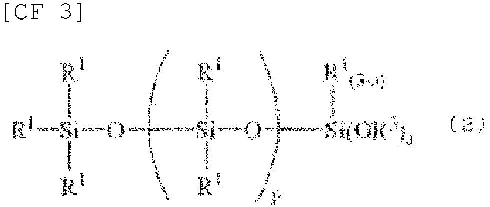

In the formula,
R¹ each is independently an unsubstituted or substituted monovalent hydrocarbon group, and preferably, it is a monovalent hydrocarbon group having 1 to 3 carbon atoms;
R³ each is independently an alkyl group having 1 to 4 carbon atoms, an alkoxyalkyl group, an alkenyl group, or an acyl group;
p is an integer from 5 to 100, preferably from 10 to 50; and
'a' is an integer from 1 to 3.

### Examples:

The present invention will be further specifically described with reference to the following experimental examples. Methods for measuring the respective physical properties employed in the experiments are as follows.

### [Wet particle size distribution measurement]

A particle size distribution measuring device MT3000 manufactured by Nikkiso Co., Ltd. was used for the measurement.

Measurement samples were prepared in the following manner.

First, 20 g of ethanol as a dispersion medium was introduced into a 50mL screw-tube bottle, and 1 g of hexagonal boron nitride (h-BN) powder was dispersed in the ethanol. The particle size distribution thereof was measured using a laser diffraction scattering particle size distribution meter.

This measurement was performed without ultrasonication or the like so as not to break the aggregated particles. The presence proportion of particles having a particle diameter of about 5 to 20 um was determined from the volume frequency distribution of the obtained particle diameter. In the measurement, D₅₀ is the value of the particle diameter at which the cumulative value of the volume frequency is 50%; D₉₅ is the value of the particle diameter at which the cumulative value of the volume frequency is 95%, and D₁₀₀ is the value of the particle diameter at which the cumulative value of the volume frequency is 100%.

### [Ultrasonication wet particle size distribution measurement]

A particle size distribution measuring device MT3000 manufactured by Nikkiso Co., Ltd. was used for the measurement.

Measurement samples were prepared in the following manner. First, 20 g of ethanol as a dispersion medium was introduced into a 50mL screw-tube bottle, and 1 g of h-BN powder was dispersed in the ethanol. The particle size distribution was measured using a laser diffraction scattering particle size distribution meter. At this time, an ultrasonication was performed at 90 W for 20 minutes in order to break the aggregated particles. The value of the particle diameter at which the cumulative value of the volume frequency became 50% was determined as D_{50S} from the volume frequency distribution of the obtained particle diameter.

### [BET specific surface area]

The BET specific surface area of the h-BN powder was calculated using a specific surface area analyzer (FlowSorb 2-2300 model manufactured by Shimadzu Corporation) by a BET method (nitrogen-adsorbing one point method).

### [Oxygen-carbon analysis]

The oxygen content in the h-BN powder was measured using an oxygen/nitrogen analyzer EMGA-620 manufactured by Horiba, Ltd. The carbon content was measured by a carbon analyzer (EMIA-110 manufactured by Horiba, Ltd.).

All of the h-BN powders used in the experiments of the present invention had oxygen contents ranging from 0.01% to 0.95% by mass and carbon contents ranging from 0.001% to 0.050% by mass.

### [Impurity boron oxide amount]

Into a 150cc beaker, 50 g of aqueous solution of sulfuric acid of a concentration of 0.04 mol/L and 2 g of h-BN powder were introduced, shaken and stirred, and then, allowed to stand for 120 minutes. During the process, the temperature of the liquid was adjusted to 25°C.

Thereafter, boron in the obtained liquid was analyzed with an ICP Optical emission spectrometer (iCAP6500 manufactured by THERMO FISHER Scientific Inc.), and the measured amount of boron was converted into B₂O₃, which was divided by the mass of h-BN powder to determine the amount of impurity boron oxide (ppm).

All of h-BN powders used in the following experiments had an impurity boron oxide content of 250 ppm or less.

### [Grind gauge measurement particle diameter]

Evaluation was conducted using a grind gauge (grain gauge) with a width 90 mm, a length 240 mm and a maximum depth of 50 um according to JIS-K5600-2-5.

Into a 24ml plastic ointment pot, 0.4 g of h-BN powder and 4 g of silicone resin having a kinematic viscosity of 1000 cSt at 25°C (Element14 PDMS 1000-J manufactured by Momentive Performance Materials Inc.) were introduced, and the pot was subjected to a process with a planetary centrifugal mixer (ARE-310 manufactured by THINKY CORPORATION) for 2 minutes at an orbital speed of 2000 rpm and a rotation velocity of 800 rpm, whereby a paste for measurement was obtained.

The paste for measurement was placed on a grind gauge, a scraper was applied perpendicularly thereto and slid on the groove in order to observe a point at which remarkable spots first appeared. The observation was conducted at intervals of 2.5 um, and the largest point containing five or more particles in a width of 3 mm across the groove was determined as the grind gauge measurement particle diameter d_{G}.

The operation was carried out at n = 6, and the average value of six operations was employed as the grind gauge measurement particle diameter.

### [Thermal conductivity]

The thermal conductivity (W/m·K) of the produced resin sheet was calculated by the thermal diffusivity (m²/sec.) × density (kg/m³) × specific heat (J/kg-K).

The thermal diffusivity was measured by a temperature wave analysis (ai-Phase Mobile manufactured by ai-Phase Co., Ltd., according to ISO 22007-3), the density was measured by Archimedian method (XS204V manufactured by METTLER TOLEDO), and the specific heat was measured by a differential scanning calorimeter (DSC) method (Thermo Plus EVO DSC8230 manufactured by Rigaku Corporation).

### [Dielectric strength]

The dielectric strength (kV/mm) of the produced resin sheet was measured according to JIS K6911 testing methods for thermosetting plastics, using a withstand voltage tester (YPAD-0225 manufactured by KYONAN ELECTRIC CO., LTD.).

### [Aspect ratio]

The aspect ratio of the h-BN primary particles was measured using an analytical scanning electron microscope (S-3400N manufactured by Hitachi High Technologies Corp.).

One hundred different h-BN primary particles were selected randomly with reference to the scanning electron microscopic observation image of 5000 magnification. The length of the major axis and the thickness of the h-BN primary particles were measured to calculate the respective aspect ratios (length of major axis / length of thickness) to set the average value as the aspect ratio.
Consequently, in all of the experiments, the aspect ratios of the h-BN fell within the range from 5 to 15.

### [Measurement of slurry viscosity]

The hexagonal boron nitride slurry as the raw material was subjected to a measurement using a viscometer (ASJ-8ST supplied by AS ONE Corporation) at a rotational speed of 3 rpm. In all of the Examples, the hexagonal boron nitride slurry as the raw material at 25°C had a viscosity within the range of 1 to 60 mPa·S.

### <Experiment 1>

The experiment was conducted to confirm the suitability of the h-BN powder of the present invention as a filler for resin sheet.

### <Experiment 1-1>

Using a spartan mixer, 1950 g of boron oxide, 710 g of carbon black and 552 g of calcium carbonate were mixed.

The (B/C) element ratio in the mixture was 0.95. The mass content ratio of the oxygen-containing calcium compound in terms of CaO with respect to 100 parts by mass of the total mass of the oxygen-containing boron compound (B₂O₃) and the carbon source (C) was 11.6 parts by mass.

The mixture (1500 g) was nitrided using a graphite-made Tammann furnace, by retaining for 6 hours at 1500°C in a gaseous nitrogen atmosphere, and for 2 hours at 1600°C, whereby a nitride was obtained.

Subsequently, the nitride was crushed and introduced into a vessel, to which hydrochloric acid (7% by mass of HCl) of 5 times the amount of the nitride was added, and the mixture was stirred at 350 rpm for 24 hours at a three-one motor for the purpose of acid pickling.

After the acid pickling, the acid was filtered. Then, the nitride obtained by the filtration was dispersed in pure water of the same amount as the acid, and filtered again. This operation was repeated until the aqueous solution after filtration became neutral, followed by drying under vacuum at 200°C for 12 hours. After the drying, the obtained powder was subjected to a sieve having a sieve opening of 45 um to obtain a raw material powder (h-BN particulate matter).

This raw material powder was mixed with pure water to prepare a 4% by mass of raw material slurry (h-BN particulate matter : pure water = 1 mass : 25 mass).

Then, using a slurry cleaner manufactured by ACO JAPAN CO., LTD.,5 L of pure water was passed through a nylon cylindrical filter having a sieve opening of 25 um. The screws located inside the cylindrical filter at this time rotated at a rotational speed of 50 Hz and at a rotational angle of 40°.

After passing pure water in this manner, 10 L of the raw material slurry was introduced into the cylindrical filter at a rate of 1 L/min. to carry out a wet classification, thereby obtaining a filter-passed slurry (classified slurry).

This classified slurry was filtered off to obtain a dehydrated cake. This dehydrated cake was vacuum-dried at 200°C, and then, the target h-BN powder was obtained.

The powder remaining on the filter and the powder obtained by drying the slurry that did not pass through the filter were less than 5% by mass relative to the raw material h-BN particulate matter, while 95% by mass or more of the raw material powder passed through the 25um filter. The production conditions are shown in Table 1, and the results of evaluation on the obtained h-BN powder are shown in Tables 2 and 3.

### <Experiments 1-2 to 1-10>

The same procedures as in Experiment 1-1 were carried out except that the respective conditions were changed as shown in Table 1. The production conditions are shown in Table 1, and the evaluation results for the obtained h-BN powders are shown in Tables 2 and 3.

### <Experiments 1-11 to 1-15>

The same procedures as in Experiment 1-1 were carried out except that the respective conditions were changed as shown in Table 1. As for Experiment 1-11 to Experiment 1-13, the grind gauge measurement particle diameter d_{G} was measured using a grind gauge of 100 um. The production conditions are shown in Table 1, and the evaluation results for the obtained h-BN powders are shown in Tables 2 and 3.

### <Experiment 1-16>

A commercially available BN powder was subjected to wet classification in the same manner as in Experiment 1-1 as shown in Table 1. The production conditions are shown in Table 1, and the evaluation results for the obtained h-BN powder are shown in Tables 2 and 3.

**[Table 1]**

| Experiment No. | Nitriding conditions | | | Wet classification conditions | | Raw material powder (h-BN particulate matter) |
|---|---|---|---|---|---|---|
| | BIC ratio | CaO amount* | Maximum temp. (°C) | Filter sieve opening (µm) | Raw material concentration in slurry (mass%) | Particle size distribution D50 (µm) |
| Experiment 1-1 | 0.95 | 12 | 1600 | 20 | 4 | 8.0 |
| Experiment 1-2 | 0.95 | 12 | 1600 | 15 | 10 | 8.0 |
| Experiment 1-3 | 0.95 | 12 | 1550 | 15 | 4 | 7.0 |
| Experiment 1-4 | 0.95 | 12 | 1650 | 15 | 4 | 8.4 |
| Experiment 1-5 | 0.95 | 12 | 1600 | 25 | 4 | 8.0 |
| Experiment 1-6 | 0.98 | 12 | 1600 | 15 | 4 | 8.0 |
| Experiment 1-7 | 0.95 | 10 | 1600 | 15 | 4 | 7.7 |
| Experiment 1-8 | 0.95 | 14 | 1600 | 15 | 4 | 7.6 |
| Experiment 1-9 | 0.95 | 12 | 1450 | 15 | 4 | 5.3 |
| Experiment 1-10 | 0.95 | 12 | 1500 | 15 | 4 | 5.8 |
| Experiment 1-11 | 0.95 | 12 | 1600 | No classification | - | 8.0 |
| Experiment 1-12 | 0.95 | 12 | 1650 | 30 | 4 | 8.9 |
| Experiment 1-13 | 0.95 | 12 | 1800 | 15 | 4 | 21.1 |
| Experiment 1-14 | 0.95 | 12 | 1600 | 10 | 4 | 8.0 |
| Experiment 1-15 | 0.95 | 12 | 1600 | 15 | 15 | 5.9 |
| Experiment 1-16 | - | - | - | 15 | 4 | 1.8 |

| | | | | | | |
|---|---|---|---|---|---|---|
| * Parts by mass in terms of CaO relative to total amount 100 parts by mass of boron compound (in terms of B₂O₃) and carbon source (in terms of C) | | | | | | |

**[Table 2]**

| Experiment No. | | | | | | | |
|---|---|---|---|---|---|---|---|
| | BET* (m²/g) | D50 (µm) | D95 (µm) | D100 (µm) | 5-20 µm proportion (vol%) | Particle diameter dG(µm) | Particle diameter dG/D100 |
| Experiment 1-1 | 4.0 | 7.6 | 14.6 | 31.1 | 86 | 41 | 1.4 |
| Experiment 1-2 | 4.1 | 7.6 | 14.5 | 31.1 | 84 | 34 | 1.1 |
| Experiment 1-3 | 5.6 | 6.8 | 13.7 | 28.5 | 78 | 32 | 1.1 |
| Experiment 1-4 | 3.3 | 8.2 | 16.9 | 31.1 | 90 | 38 | 1.2 |
| Experiment 1-5 | 4.0 | 7.8 | 14.8 | 31.1 | 87 | 44 | 1.4 |
| Experiment 1-6 | 3.8 | 7.8 | 15.2 | 31.1 | 86 | 36 | 1.2 |
| Experiment 1-7 | 4.3 | 7.2 | 14.0 | 31.1 | 83 | 33 | 1.1 |
| Experiment 1-8 | 4.2 | 7.6 | 14.5 | 31.1 | 84 | 39 | 1.3 |
| Experiment 1-9 | 6.5 | 5.2 | 13.7 | 23.9 | 52 | 44 | 1.8 |
| Experiment 1-10 | 5.9 | 5.7 | 14.7 | 26.9 | 52 | 44 | 1.6 |
| Experiment 1-11 | 4.0 | 7.9 | 15.1 | 40.3 | 86 | 70 | 1.2 |
| Experiment 1-12 | 3.3 | 8.1 | 16.6 | 33.9 | 86 | 50 | 1.5 |
| Experiment 1-13 | 2.0 | 13.1 | 25.9 | 52.3 | 79 | 55 | 1.1 |
| Experiment 1-14 | 4.2 | 4.8 | 11.6 | 28.5 | 48 | 34 | 1.2 |
| Experiment 1-15 | 4.1 | 4.9 | 12.5 | 29.2 | 45 | 36 | 1.2 |
| Experiment 1-16 | 13.0 | 1.2 | 3.2 | 8.1 | 2 | 47 | 5.8 |

| | | | | | | | |
|---|---|---|---|---|---|---|---|
| BET = Specific surface area | | | | | | | |

**[Table 3]**

| Experiment No. | | |
|---|---|---|
| | D50S (µm) | D50S/D50 |
| Experiment 1-1 | 4.2 | 0.55 |
| Experiment 1-2 | 4.6 | 0.61 |
| Experiment 1-3 | 3.8 | 0.56 |
| Experiment 1-4 | 5.8 | 0.71 |
| Experiment 1-5 | 4.8 | 0.62 |
| Experiment 1-6 | 4.8 | 0.62 |
| Experiment 1-7 | 4.2 | 0.58 |
| Experiment 1-8 | 4.6 | 0.61 |
| Experiment 1-9 | 3.2 | 0.62 |
| Experiment 1-10 | 3.8 | 0.67 |
| Experiment 1-11 | 6.0 | 0.76 |
| Experiment 1-12 | 5.9 | 0.73 |
| Experiment 1-13 | 7.1 | 0.54 |
| Experiment 1-14 | 3.5 | 0.73 |
| Experiment 1-15 | 3.6 | 0.73 |
| Experiment 1-16 | 0.7 | 0.58 |

### <Filler evaluation test A>

The hexagonal boron nitride (h-BN) powders obtained in Experiments 1-1 to 1-16 were mixed with an epoxy resin to prepare resin compositions. Regarding resin sheets formed of the resin compositions, the thermal conductivity and the insulating strength were measured. With reference to the results, the h-BN powder as a filler for a resin sheet was evaluated.

For the epoxy resin, a curable epoxy resin JER828 manufactured by Mitsubishi Chemical Corporation was used.

For the epoxy-curing agent, an imidazole-based curing agent CUREZOL 2E4MZ manufactured by SHIKOKU CHEMICALS CORPORATION was used.

A varnish-like mixture was prepared by mixing 100 parts by mass of the epoxy resin, 5 parts by mass of the curing agent, and 210 parts by mass of methyl ethyl ketone (solvent).

The varnish-like mixture and the h-BN powder were mixed in a planetary centrifugal mixer to obtain a resin composition. As for the proportion, the resin was 35 vol% and the h-BN powder was 65 vol%.

For the planetary centrifugal mixer, MAZERUSTAR manufactured by KURABO INDUSTRIES LTD. was used.

The resin composition was coated and dried on a PET film to a thickness of about 60 um, using Auto Film Applicator PI-1210 manufactured by TESTER INDUSTRY CO., LTD., and cured under reduced pressure and under the conditions described below to obtain a resin sheet having a thickness of 45 um.
Temperature: 200°C
Pressure: 5 MPa
Retention time: 30 minutes

As for the resin composition prepared using the h-BN powder produced in Experiment 1-2, the coating amount was reduced to make a resin sheet having a thickness of 35 µm.

The measurement results for the thermal conductivity and dielectric strength of the obtained resin sheets are shown in Table 4.

**[Table 4]**

| Experiment No. | Resin sheet physical properties | |
|---|---|---|
| | Thermal conductivity (W/m•K) | Dielectric strength (kV/mm) |
| Experiment 1-1 | 3.2 | 87 |
| Experiment 1-2 | 3.5 | 78 |
| Experiment 1-3 | 3.6 | 88 |
| Experiment 1-4 | 4.0 | 77 |
| Experiment 1-5 | 3.8 | 78 |
| Experiment 1-6 | 3.2 | 83 |
| Experiment 1-7 | 3.3 | 82 |
| Experiment 1-8 | 3.4 | 83 |
| Experiment 1-9 | 2.8 | 76 |
| Experiment 1-10 | 2.9 | 77 |
| Experiment 1-11 | 3.2 | 66 |
| Experiment 1-12 | 3.0 | 72 |
| Experiment 1-13 | 4.0 | 59 |
| Experiment 1-14 | 2.7 | 79 |
| Experiment 1-15 | 2.6 | 78 |
| Experiment 1-16 | 2.0 | 73 |

As can be understood from the experimental results in Table 4, the resin sheets in which the h-BN powders prepared in Experiments 1-1 to 1-10 were blended had not only a high thermal conductivity of 2.8 W/m·K or more but also a high dielectric strength of 75 kV/mm or more.

On the other hand, any of the resin sheets in which the h-BN powders prepared in Experiments 1-11 to 1-16 were blended did not satisfy the thermal conductivity of 2.8 W/m·K or more and the dielectric strength of 75 kV/mm or more at the same time.

### <Experiment 2>

Here, an experiment for confirming the suitability of the h-BN powder of the present invention as a filler for a sealing material is performed.

### <Experiment 2-1>

The reactive components for forming the h-BN were mixed using a mortar, according to the formula below.
Boron oxide: 50 g
Melamine: 40 g
Anhydrous borax: 80 g

By raising the temperature to 1200°C in a gaseous nitrogen atmosphere using a graphite-made Tammann furnace, the mixture was heated at 1200°C for 12 hours to obtain a nitrided powder by a melamine method.

Subsequently, the nitrided powder was crushed in a millstone type grinder, and then introduced into a polyethylene vessel. To 100 g of this nitrided powder, 100 g of hydrochloric acid (37% by mass of HCl) and 300 g of pure water were added to prepare an acid slurry. This acid slurry was stirred for 8 hours to conduct acid pickling.

After the acid pickling, the acid slurry was filtrated using a Buchner funnel, which was then washed with pure water of an amount 10 times or more the nitrided powder (weight ratio). Then, dehydration was performed by suction filtration, so that the moisture content of the nitrided powder became 40% by mass or less. Later, it was vacuum-dried for 12 hours at 200°C.

After the drying, the obtained powder was subjected to a sieve having a sieve opening of 90 um, whereby a raw material powder composed of h-BN particulate matter was obtained. The powder would be used for adjusting the particle size.

Water was added to the raw material powder to prepare a raw material slurry (h-BN particulate matter : pure water = 1 part by mass : 25 parts by mass) containing a raw material powder at a concentration of 4% by mass.

Subsequently, using a slurry screener manufactured by ACO JAPAN CO., LTD., 5 L of pure water was passed through a nylon cylindrical filter having a sieve opening of 25 um. At this time, the screws located inside the cylindrical filter rotated at a rotational speed of 50 Hz and at a rotational angle of 40°.

After passing the pure water in this manner, 10 L of the raw material slurry was introduced into the cylindrical filter at a rate of 1 L/min. to conduct wet classification, thereby obtaining a filter-passed slurry (classified slurry).

This classified slurry was filtered off to obtain a dehydrated cake. This dehydrated cake was vacuum-dried at 200°C, and then, subjected to a procedure with a dry sieve having a sieve opening of 90 um, whereby a target h-BN powder was obtained.

The powder remaining on the filter and the powder obtained by drying the slurry that did not pass through the filter were less than 5% by mass relative to the raw material powder (h-BN particulate matter), while 95% by mass or more of the raw material powder passed through the 10pm filter.
Tables 5, 6 and 7 show the evaluation results of the h-BN powder having particle size adjusted by the production conditions and classification.

### <Experiment 2-2 to Experiment 2-7>

Production of the raw material powder and wet classification were performed in the same manner as in Experiment 2-1 except that the respective conditions were changed as shown in Table 5.

Tables 5, 6 and 7 show the evaluation results of the h-BN powder having particle size adjusted by the production conditions and classification.

### <Experiment 2-8 to Experiment 2-11>

Production of the raw material powder and wet classification were performed in the same manner as in Experiment 2-1 except that the respective conditions were changed as shown in Table 5.

Tables 5, 6 and 7 show the evaluation results of the h-BN powder having particle size adjusted by the production conditions and classification.

### <Experiment 2-12>

A commercially available BN powder was subjected to wet classification in the same manner as in Experiment 2-1 as shown in Table 5. The production conditions and the evaluation results of the obtained hexagonal boron nitride powder are shown in Tables 5, 6 and 7.

### <Experiment 2-13>

In an attempt of wet classification in the same manner as in Experiment 2-1 except that the concentration of the raw material powder (h-BN particulate matter) in the raw material slurry was changed to 15% by mass, very little of the slurry passed through the screen, and controlling the particle size (removal of coarse particles) was impossible due to the high slurry concentration and the high viscosity.

**[Table 5]**

| Experiment No. | Melamine method maximum temp. (°C) | Wet classification condition | | Raw material powder (h-BN particles) |
|---|---|---|---|---|
| | | Filter sieve opening (µm) | Raw material concentration in slurry (mass%) | Particle size distribution D50 (µm) |
| Experiment 2-1 | 1200 | 10 | 4 | 2.6 |
| Experiment 2-2 | 1200 | 10 | 10 | 2.6 |
| Experiment 2-3 | 1200 | 15 | 4 | 2.6 |
| Experiment 2-4 | 1200 | 7 | 4 | 2.6 |
| Experiment 2-5 | 1200 | 5 | 4 | 2.6 |
| Experiment 2-6 | 1300 | 10 | 4 | 3.2 |
| Experiment 2-7 | 1350 | 10 | 4 | 3.7 |
| Experiment 2-8 | 1200 | No classification | - | 2.6 |
| Experiment 2-9 | 1200 | 20 | 4 | 2.6 |
| Experiment 2-10 | 1550 | 10 | 4 | 4.4 |
| Experiment 2-11 | 1200 | 3 | 4 | 2.6 |
| Experiment 2-12 | - | 10 | 4 | 1.8 |
| Experiment 2-13 | 1200 | 10 | 15 | 2.6 |

**[Table 6]**

| Experiment No. | Hexagonal boron nitride powder | | | | | | |
|---|---|---|---|---|---|---|---|
| | BET* (m²/g) | D50 (µm) | D95 (µm) | D100 (µm) | 2.0-5.0 µm particle proportion (vol%) | Particle diameter dG (µm) | Particle diameter dG /D100 |
| Experiment 2-1 | 9.1 | 2.3 | 5.2 | 11.0 | 67 | 14 | 1.3 |
| Experiment 2-2 | 9.0 | 2.4 | 5.3 | 11.0 | 64 | 18 | 1.6 |
| Experiment 2-3 | 9.1 | 2.5 | 5.7 | 11.0 | 63 | 23 | 2.1 |
| Experiment 24 | 9.0 | 2.2 | 5.1 | 11.0 | 52 | 13 | 1.2 |
| Experiment 2-5 | 9.0 | 2.1 | 4.9 | 8.8 | 50 | 9 | 1.0 |
| Experiment 2-6 | 8.0 | 3.0 | 6.0 | 12.0 | 57 | 19 | 1.6 |
| Experiment 2-7 | 7.0 | 3.5 | 6.5 | 13.1 | 58 | 28 | 2.1 |
| Experiment 2-8 | 9.2 | 2.6 | 6.1 | 13.1 | 63 | 50 | 3.8 |
| Experiment 2-8 | 9.1 | 2.6 | 5.8 | 13.1 | 61 | 32 | 2.4 |
| Experiment 2-10 | 5.9 | 4.2 | 8.8 | 18.1 | 58 | 38 | 2.1 |
| Experiment 2-11 | 9.0 | 1.8 | 4.8 | 8.5 | 42 | 9 | 1.1 |
| Experiment 2-12 | 13.0 | 1.1 | 3.1 | 8.5 | 35 | 33 | 3.9 |

| | | | | | | | |
|---|---|---|---|---|---|---|---|
| BET = Specific surface area | | | | | | | |

**[Table 7]**

| Experiment No. | | |
|---|---|---|
| | D50S (µm) | D50S/D50 |
| Experiment 2-1 | 1.3 | 0.57 |
| Experiment 2-2 | 1.4 | 0.58 |
| Experiment 2-3 | 1.5 | 0.60 |
| Experiment 2-4 | 1.2 | 0.55 |
| Experiment 2-5 | 1.0 | 0.48 |
| Experiment 2-6 | 2.6 | 0.87 |
| Experiment 2-7 | 2.8 | 0.80 |
| Experiment 2-8 | 1.5 | 0.58 |
| Experiment 2-9 | 1.5 | 0.58 |
| Experiment 2-10 | 3.2 | 0.76 |
| Experiment 2-11 | 1.2 | 0.67 |
| Experiment 2-12 | 0.7 | 0.64 |

### <Filler evaluation test B>

The hexagonal boron nitride (h-BN) powders obtained in Experiments 2-1 to 2-12 were mixed with an epoxy resin to prepare resin compositions, and the thermal conductivity of resin sheets formed of the resin compositions was measured. From the results, the h-BN powders were evaluated as fillers for a sealing material.

The epoxy resin and the epoxy curing agent used in the filler evaluation test A were prepared also for the test.

A varnish-like mixture was prepared by mixing 100 parts by mass of the epoxy resin, 5 parts by mass of the curing agent, and 210 parts by mass of methyl ethyl ketone (solvent).

The varnish-like mixture and the h-BN powder were mixed in the same manner as in the filler evaluation test A, where the resin was 35 vol% and the h-BN powder was 65 vol%, thereby obtaining a resin composition.

Using Auto Film Applicator PI-1210 manufactured by TESTER INDUSTRY CO., LTD., the resin composition was coated and dried on a PET film such that the thickness would be about 25 um, and the solvent was removed.

Subsequently, two of the thus formed coating sheets having a thickness of 25 um were bonded together and cured under reduced pressure under the conditions as described below, whereby a resin sheet having a thickness of 30 um was formed on the PET film.
Temperature: 200°C
Pressure: 5 MPa
Retention time: 30 minutes

As for the resin composition prepared using the h-BN powder of Experiment 2-5, the coating amount was changed to prepare also a resin sheet having a thickness of 10 µm.

The thermal conductivity of the obtained resin sheet was measured, and the results are shown in Table 8.

### <Filler evaluation test C (gap permeability test)>

The hexagonal boron nitride (h-BN) powders obtained in Experiment 2-1 to Experiment 2-12 were mixed with an epoxy resin to prepare a resin composition, and the gap permeability was evaluated. Based on this evaluation, the evaluation of the h-BN powder as a filler for a sealing material was performed.

For the resin, a liquid epoxy resin YDF-8170C manufactured by NIPPON STEEL Chemical & Material Co., Ltd. was used.

The h-BN powder (0.85 g) and liquid epoxy resin (3 g) were introduced into a 24ml plastic ointment pot, and this ointment pot was subjected to a process with a planetary centrifugal mixer at an orbital speed of 2000 rpm and a rotation velocity of 800 rpm for 2 minutes to obtain a resin composition. For the planetary centrifugal mixer, ARE-310 manufactured by THINKY CORPORATION was used.

Two glass slides (76 × 26 mm, thickness: 1.0 mm) were pasted together with a 1 cm gap, adhered with double-sided tape, and then heated to 100°C for 3 minutes on a hot plate (HHP-170D, manufactured by Azwan Corporation).

For the double-sided tape, a double-sided tape NO.5603 (thickness: 30 um) or NO.5601 (thickness: 10 um) each manufactured by Nitto Denko Corporation was used. The aforementioned gap was adjusted to be 30 um, 20 um or 10 um.

In a state of being heated to 100°C, the two bonded glass slides were laid down, and the resin composition (0.005 to 0.01 g) prepared in the aforementioned manner was dropped onto end portions of the laid glass slides to allow the resin composition to permeate into the gap. The gap permeation distance after 1 minute of the start of permeation was measured with a ruler. No permeation is indicated with "×" in the Table.

The results are shown in Table 8.

**[Table 8]**

| Experiment No. | Thermal conductivity (W/m · K) | | Gap permeability | | |
|---|---|---|---|---|---|
| | Sheet thickness 30 µm | Sheet thickness 10 µm | Gap 30 µm | Gap 20 µm | Gap 10 µm |
| Experiment 2-1 | 2.4 | - | 15 mm | 12 mm | 1 mm |
| Experiment 2-2 | 2.5 | - | 15 mm | 12 mm | 1 mm |
| Experiment 2-3 | 2.6 | - | 13 mm | 2 mm | × |
| Experiment 2-4 | 2.3 | - | 19 mm | 14 mm | 2 mm |
| Experiment 2-5 | 2.3 | 2.3 | 20 mm | 15 mm | 7 mm |
| Experiment 2-6 | 2.2 | - | 15 mm | 11 mm | 1 mm |
| Experiment 2-7 | 2.5 | - | 12 mm | 3 mm | × |
| Experiment 2-8 | 2.3 | - | 3 mm | × | × |
| Experiment 2-8 | 2.2 | - | 4 mm | × | × |
| Experiment 2-10 | 2.2 | - | 4 mm | × | × |
| Experiment 2-11 | 1.7 | - | 21 mm | 15 mm | 7 mm |
| Experiment 2-12 | 1.6 | - | 2 mm | × | × |

The measurement results of the thermal conductivity (Filler evaluation test B), show that the resin compositions containing the h-BN powders of Experiment 2-1 to Experiment 2-10, in which the proportion of the particles of 2.0 to 5.0 um was 50 vol% or more, had high thermal conductivity in a case where the resin composition was formed into the resin sheets having a film thickness of 10 to 30 um.

In the test, the thermal conductivity of the resin sheet is measured. Here, the sealing material filled to the same degree of thickness is present in a sheet-like shape, and the mechanism of the thermal conduction path formation is common in the sheet and the sealing material. Therefore, it can be said that a resin composition containing a h-BN powder having particles of 2.0 to 5.0 um in proportion of 50 vol% or more can obtain a high thermal conductivity as in the case of a resin sheet even when filled as a sealing material in a gap of 10 to 30 um.

Further, the results of the permeability test (filler evaluation test C) show the permeability is remarkably increased when the grind gauge measurement particle diameter of the h-BN powder is smaller than the gap size. This indicates that making the grind gauge measurement particle diameter d_{G} of the hexagonal boron nitride powder to be smaller than the gap size to be filled with the sealing material will serve to improve the gap permeability, prevent or reduce clogging, and thus, it can effectively prevent problems such as uneven filling, voids and molding failure.

## Claims

1. A hexagonal boron nitride powder having a particle size distribution by a wet method in which the proportion of particles within a particle diameter range of 2.0 to 20 um is not less than 50 vol%, and having a particle diameter d_{G} by a grind gauge measurement of not more than 44 um.

2. The hexagonal boron nitride powder according to claim 1, wherein the proportion of particles in a particle diameter range of 5.0 to 20 um in the particle size distribution by the wet method is not less than 50 vol%.

3. The hexagonal boron nitride powder according to claim 2, wherein a ratio d_{G}/D₁₀₀ of the particle diameter d_{G} to an accumulated particle diameter D₁₀₀ in terms of volume in the particle size distribution by the wet method is 1.0 to 1.6.

4. The hexagonal boron nitride powder according to claim 1, wherein in the particle size distribution by the wet method, the proportion of the particles within the particle diameter range of 2.0 to 5.0 um is not less than 50 vol%, and the particle diameter d_{G} is not more than 29 um.

5. The hexagonal boron nitride powder according to claim 4, wherein the ratio d_{G}/D₁₀₀ of the particle diameter d_{G} to the accumulated particle diameter D₁₀₀ in terms of volume in the particle size distribution by the wet method is 1.0 to 2.3.

6. A resin composition comprising the hexagonal boron nitride powder according to claim 1, wherein the hexagonal boron nitride powder is dispersed in a resin in an amount of 30 to 90 vol%.

7. The resin composition according to claim 6, wherein the resin is a silicone resin or an epoxy resin.

8. The resin composition according to claim 6, which is to be used for forming a resin sheet, wherein the proportion of particles of the hexagonal boron nitride powder within the particle diameter range of 5.0 to 20 um in the particle size distribution by the wet method is not less than 50 vol%.

9. The resin composition according to claim 8, wherein the resin sheet has a thickness in a range of 20 to 45 um.

10. The resin composition according to claim 6, which is to be used for forming a sealing material, wherein the proportion of particles of the hexagonal boron nitride powder within the particle diameter range of 2.0 to 5.0 um in the particle size distribution by the wet method is not less than 50 vol%, and the particle diameter d_{G} by the grind gauge measurement is not more than 29 um.

11. The resin composition according to claim 10, wherein the sealing material is used for filling a small gap of not larger than 30 um in a semiconductor device.

12. A method for producing a hexagonal boron nitride powder according to claim 1, the method comprising:
preparing a raw material powder of a particulate matter of hexagonal boron nitride having a particle size distribution by a wet method in which a proportion of particles within a particle diameter range of 2.0 to 20 um is not less than 50 vol%;
dispersing the raw material powder in a solvent to prepare a raw material slurry in which the concentration of the raw material powder is not more than 14% by mass;
wet classification for removing coarse particles by passing the raw material slurry through a filter having a sieve opening of 5 um to 25 um; and
drying for removing the solvent from the slurry from which the coarse particles have been removed.

13. The method according to claim 12, wherein a median particle diameter D₅₀ of the raw material powder in terms of volume in particle size distribution by a wet method is in the range of 5.0 to 20 um, and the filter to be used for removing the coarse particles has a sieve opening in the range of 15 um to 25 um.

14. The method according to claim 12, wherein a median particle diameter D₅₀ of the raw material powder in terms of volume in particle size distribution by a wet method is in the range of 2.0 to 4.0 um, and the filter to be used for removing the coarse particles has a sieve opening in the range of 5 um to 15 um.
